# EUROPEAN PATENT APPLICATION

(11) **EP 2 492 973 A2**
(43) Date of publication of application: **29.08.2012**
(21) Application number: 11167411.5
(22) Date of filing: 25.05.2011
(51) Int. Cl.: H01L 33/12, H01L 33/00

(54) **Nitride based light emitting device with excellent crystallinity and brightness and method of manufacturing the same**

(30) Priority: 28.02.2011 KR 20110018227
(71) Applicant: Semimaterials Co., Ltd., Sengnam-si, Gyeonggi-do 463-400 (KR); Park, Kun, Bundang-gu Sengnam-si, Gyeonggi-do 463-440 (KR)
(72) Inventor: Park, Kun, Gyeonggi-do 463-440 (KR); Jin, Joo, Gyeonggi-do 449-853 (KR)
(74) Representative: Müller Schupfner & Partner

(57) **Abstract**

Disclosed is a nitride-based light emitting device capable of improving crystallinity and brightness. The nitride-based light emitting device includes a growth substrate, a lattice buffer layer formed on the growth substrate, a p-type nitride layer formed on the lattice buffer layer, a light emitting active layer formed on the p-type nitride layer, and an n-type ZnO layer formed on the light emitting active layer. The lattice buffer layer is formed of powders of a material having a Wurtzite lattice structure. The lattice buffer layer is formed of ZnO powders, thereby minimizing generation of dislocations during nitride growth. A method of manufacturing the same is also disclosed.

## Description

### BACKGROUND

### 1. Technical Field

The present invention relates to a technique for manufacturing a nitride-based light emitting device.

### 2. Description of the Related Art

A light emitting device is a semiconductor device based on a luminescence phenomenon occurring upon recombination of electrons and holes in the device.

For example, nitride-based light emitting devices such as GaN light emitting devices are widely used. The nitride-based light emitting devices can realize a variety of colors due to high band-gap energy thereof. Further, the nitride-based light emitting devices exhibit excellent thermal stability.

The nitride-based light emitting devices may be classified into a lateral type and a vertical type according to arrangement of an n-electrode and a p-electrode therein. The lateral type structure generally has a top-top arrangement of the n-electrode and the p-electrode and the vertical type structure generally has a top-bottom arrangement of the n-electrode and the p-electrode.

### BRIEF SUMMARY

One aspect of the present invention is to provide a nitride-based light emitting device and a method of manufacturing the same which can enhance crystallinity and brightness by suppressing occurrence of dislocations upon growth of a nitride layer on a growth substrate.

In accordance with one aspect of the invention, a nitride-based light emitting device includes: a growth substrate; a lattice buffer layer formed on the growth substrate; a p-type nitride layer formed on the lattice buffer layer; a light emitting active layer formed on the p-type nitride layer; and an n-type ZnO layer formed on the light emitting active layer. Here, the lattice buffer layer is formed of powder of a material having a Wurtzite lattice structure.

The lattice buffer layer may be formed of ZnO powders.

In accordance with another aspect of the invention, a method of manufacturing a nitride-based light emitting device includes: forming a lattice buffer layer on a growth substrate using powders of a material having a Wurtzite lattice structure; forming a buffer layer on the lattice buffer layer; forming a p-type nitride layer on the buffer layer; forming a light emitting active layer on the p-type nitride layer; and forming an n-type ZnO layer on the light emitting active layer.

The lattice buffer layer may be formed of ZnO powders.

The operation of forming the buffer layer may be performed in an inert atmosphere. In addition, the operation of forming the p-type nitride layer and the operation of forming the light emitting active layer may be performed in a hydrogen gas atmosphere, so that some or all of the ZnO powders are etched by hydrogen gas to form an air hole between the growth substrate and the buffer layer, thereby improving brightness of the light emitting device.

### BRIEF DESCRIPTION OF THE DRAWINGS

The above and other aspects, features, and advantages of the invention will become apparent from the detailed description of the following embodiments in conjunction with the accompanying drawings:
Fig. 1 is a schematic sectional view of a nitride-based light emitting device according to an exemplary embodiment of the present invention;
Fig. 2 is a schematic flowchart of a method of manufacturing the nitride-based light emitting device according to an exemplary embodiment of the present invention; and
Fig. 3 is a scanning electron microscope (SEM) image showing air holes formed by etching ZnO powders during growth of a nitride layer.

### DETAILED DESCRIPTION

Exemplary embodiments of the invention will now be described in detail with reference to the accompanying drawings.

It will be understood that when an element such as a layer, film, region or substrate is referred to as being "on" another element, it can be directly on the other element or intervening elements may also be present. In contrast, when an element is referred to as being "directly on" another element, there are no intervening elements present.

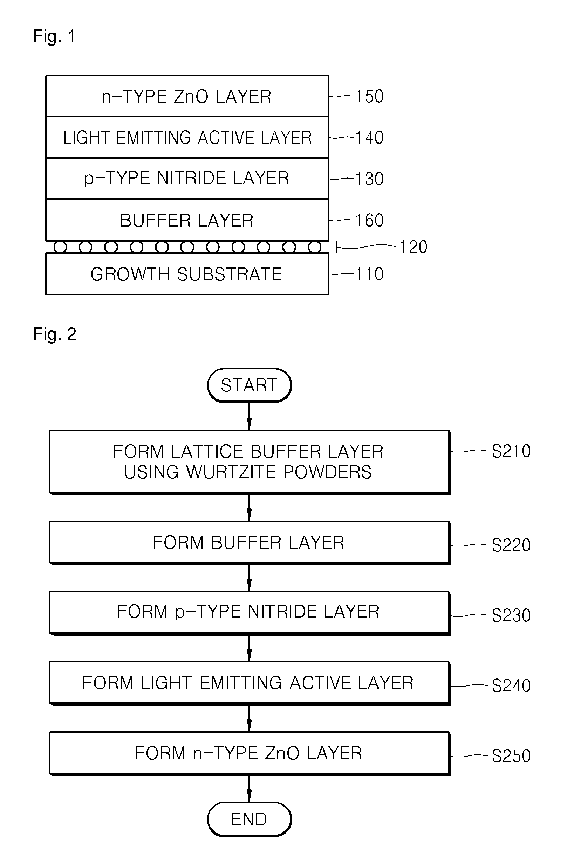

Fig. 1 is a schematic sectional view of a nitride-based light emitting device according to an exemplary embodiment of the present invention.

Referring to Fig. 1, the nitride-based light emitting device includes a growth substrate 110, a lattice buffer layer 120, a p-type nitride layer 130, a light emitting active layer 140, and an n-type ZnO layer 150.

In this embodiment, the growth substrate 110 may be a sapphire substrate which is widely used as a growth substrate in manufacture of nitride-based light emitting devices. In addition, in this embodiment, the growth substrate 110 may be a silicon substrate such as a single crystal silicon substrate, a polycrystal silicon substrate, and the like.

The lattice buffer layer 120 is formed on the growth substrate 110. The lattice buffer layer 120 relieves lattice mismatch with respect to a nitride layer to be grown, thereby suppressing occurrence of dislocations during growth of the nitride layer. As a result, it is possible to improve crystallinity of the nitride layer grown on the growth substrate.

For example, when a silicon substrate is used as the growth substrate, dislocation density increases to a great extent during growth of the nitride layer on the silicon substrate due to a great difference in lattice constant between the silicon substrate and a nitride layer, thereby causing deterioration in luminescence efficiency of the light emitting device. However, when the lattice buffer layer is formed on the silicon layer and the nitride layer is then formed on the lattice buffer layer, lattice mismatch between the nitride layer and the substrate is relieved, thereby reducing the dislocation density caused by the lattice mismatch during growth of the nitride layer

Such a lattice buffer layer 120 may be formed of powders of a material having a Wurtzite lattice structure.

More preferably, the lattice buffer layer may be formed using ZnO powders

For example, ZnO widely used in manufacture of nitride-based light emitting devices has a Wurtzite lattice structure, and lattice constants of a=3.189A and c=5.185A.

ZnO also has the Wurtzite lattice structure like GaN. Further, ZnO has lattice constants of a=3.249A and c=5.207A, so that ZnO has a very similar lattice structure to GaN.

Thus, when growing GaN on the ZnO powders, lattice match can occur therebetween, thereby minimizing occurrence of dislocations. Further, when growing GaN on the ZnO powders, the GaN is initially grown in the vertical direction and then grows in the horizontal direction, thereby enabling flat growth of the GaN.

The ZnO powders may be attached or secured to the growth substrate 110 by spin coating, or the like.

To allow the powders to be easily attached or secured to the growth substrate 110, the growth substrate 110 may have an uneven surface formed with prominences and depressions. The surface unevenness may be formed as a specific or random pattern. The surface unevenness of the growth substrate 110 may be formed by various methods such as etching or the like.

When the growth substrate 110 has the uneven surface, the ZnO powders may be easily attached or secured to the depressions of the uneven surface of the growth substrate 110.

The ZnO powder used for the lattice buffer layer 120 may have an average particle size of 10 nm ∼ 1 µm. The smaller the average particle size of the powders, the better the effect of suppressing generation of the dislocations during nitride growth. If the average particle size of ZnO powders exceeds 1 µm, the effect of suppressing generation of dislocations is insufficient, causing low luminescence efficiency of the manufactured nitride-based light emitting device. If the average particle size of ZnO powders is less than 10 nm, manufacturing costs of the ZnO powders are excessively increased, thereby causing an increase in manufacturing costs of the nitride-based light emitting device.

Next, the p-type nitride layer 130 is formed on the lattice buffer layer 120. The p-type nitride layer 130 is formed by doping a p-type impurity such as magnesium (Mg) and the like to ensure p-type electrical characteristics.

Conventionally, in the method of manufacturing a nitride-based light emitting device, the p-type nitride layer is formed at the last stage after the light emitting active layer is formed. Here, the p-type nitride layer is grown at a decreased growth temperature to suppress influence of the p-type impurity on the light emitting active layer during formation of the p-type nitride layer. As a result, crystal quality of the p-type nitride layer is deteriorated, causing deterioration of light emitting efficiency.

In this embodiment, however, the p-type nitride layer 130 is formed before the light emitting active layer 140, thereby ensuring high crystal quality of the p-type nitride layer.

The light emitting active layer 140 is formed on the p-type nitride layer 130. The light emitting active layer 140 may have a multiple quantum well (MQW) structure. For example, the light emitting active layer 140 may have a structure having InₓGa₁₋ₓN (0.1≤x≤0.3) and GaN alternately stacked one above another or a structure having InₓZn₁₋ₓO (0.1≤x≤0.3) and ZnO alternately stacked one above another.

In the light emitting active layer 140, electrons traveling through the n-type ZnO layer 150 recombine with holes traveling through the p-type nitride layer 130 to generate light.

The n-type ZnO layer 150 is formed on the light emitting active layer 140 and exhibits opposite electrical characteristics to those of the p-type nitride layer 130. Although ZnO is an n-type material, ZnO has insignificant electrical characteristics compared with those of the n-type layer formed using n-type impurities and may act merely as a current path. Thus, n-type impurities such as silicon (Si) may be doped into the n-type ZnO layer 150.

As described above, ZnO has a Wurtzite lattice structure that is substantially the same as that of GaN. In addition, since ZnO can be grown even at a temperature of about 700∼800°C, it is possible to improve crystal quality by minimizing influence on the light emitting active I40 during growth of ZnO. Thus, the n-type ZnO layer 150 applicable to the present invention can replace an n-type GaN, which is grown at high temperature of about 1200°C.

Further, application of the n-type ZnO layer 150 results in further improvement of brightness as compared with the case where the n-type GaN layer is used.

As such, in the embodiment of the invention, the p-type nitride layer 130 is first formed on the growth substrate and the n-type ZnO layer 150 is then formed on the light emitting active layer.

At this time, a p-type silicon substrate may be adopted as the growth substrate 110. When the p-type silicon substrate is adopted, p-type layers may be formed as the respective layers under the light emitting active layer 140. Further, when the p-type silicon substrate is adopted, the silicon substrate may act as a p-electrode, thereby eliminating a process of removing the substrate and a process of forming the p-electrode, even in manufacture of a vertical light emitting device.

Thus, when adopting the p-type silicon substrate, it is possible to easily fabricate not only the lateral type light emitting device but also the vertical type light emitting device which has a relatively wide light emitting area to easily realize emission of light with high brightness.

On the other hand, referring to Fig. 1, the light emitting structure may further include a buffer layer 160 between the lattice buffer layer 120 and the p-type nitride layer 130. The buffer layer 160 serves to relieve stress generated during growth of the nitride layer, which is a hetero-material, on the growth substrate. Such a buffer layer 160 may be formed of a nitride material such as AIN, ZrN, GaN, or the like.

The buffer layer 160 may be a p-type buffer layer. Nitrides for the buffer layer 160 generally have high electric resistance. However, if the buffer layer 160 is the p-type buffer layer, the buffer layer has low electric resistance. Accordingly, it is possible to improve operational efficiency of the nitride-based light emitting device

Particularly, when the buffer layer 160 is the p-type layer and a p-type silicon substrate is used as the growth substrate 110, holes can easily move from the p-type silicon substrate to the light emitting active layer 140 without interference of a barrier, thereby further improving operational efficiency of the light emitting device.

In addition, when the buffer layer 160 is a p-type buffer layer, impurities such as magnesium (Mg) in the buffer layer 160 diffuse into the growth substrate 110. In this case, the substrate exhibits electrical characteristics of the p-type layer. Thus, even if a sapphire substrate having insulation characteristics is used as the growth substrate 110, there is no need for removal of the sapphire substrate, unlike in manufacture of conventional vertical type light emitting devices.

Fig. 2 is a schematic flowchart of a method of manufacturing the nitride-based light emitting device according to an exemplary embodiment of the present invention.

Referring to Fig. 2, the method of manufacturing a nitride-based light emitting device includes forming a lattice buffer layer in operation S210, forming a buffer layer in operation S220, forming a p-type nitride layer in operation S230, forming a light emitting active layer in operation S240, and forming an n-type ZnO layer in operation S250.

In operation S21 0, the lattice buffer layer is formed on a growth substrate such as a silicon substrate or a sapphire substrate using powders of a material having a Wurtzite lattice structure.

Here, the lattice buffer layer may be formed of ZnO powders.

The ZnO powders may be a commercially available product.

In addition, the ZnO powders may be prepared by depositing ZnO on a substrate such as a silicon substrate or a sapphire substrate, more preferably, a substrate made of the same material as the growth substrate, and pulverizing the substrate having the ZnO deposited thereon into powders. Deposition of ZnO may be carried out by MOCVD or sputtering. In this case, since the ZnO powders contain not only pure ZnO components but also components of the substrate, adhesion of the ZnO powders to the growth substrate may be improved.

The lattice buffer layer may be formed using the ZnO powders in the following method.

First, ZnO powders are coated on the growth substrate using a spin coater or the like. Then, the growth substrate is heated to about 500∼800°C in a nitrogen atmosphere in a chamber, for example a CVD chamber, such that the ZnO powders are attached to the growth substrate. If the heating temperature exceeds 800°C, the ZnO powders may be etched. Thus, advantageously, the heating temperature may be below that temperature.

In this case, the growth substrate may be slightly etched to form an uneven surface. The surface unevenness of the growth substrate facilitates attachment or securing of the ZnO powders thereto.

Alternatively, the lattice buffer layer may be formed using a ZnO powder-containing solution by spin-coating the solution onto the growth substrate and drying the growth substrate. Here, the solution containing the ZnO powders may be prepared using various solvents, such as acetone, methanol, ethylene glycol, and the like.

Either or both of the methods described above may be selectively used to form the lattice buffer layer. For example, the lattice buffer layer may be formed by spin-coating and drying the ZnO powder-containing solution on the growth substrate, followed by heating the growth substrate in a chamber.

Subsequently, in operation S220 of forming a buffer layer, operation S230 of forming a p-type nitride layer, and operation S240 of forming a light emitting active layer, a plurality of nitride layers is sequentially grown on the lattice buffer layer to form a light emitting structure.

Here, the buffer layer may be formed in an inert gas atmosphere, such as helium (He) gas, argon (Ar) gas, and the like. If the buffer layer is formed in a hydrogen atmosphere, the ZnO powders are etched by hydrogen gas, so that the buffer layer cannot be sufficiently formed.

On the contrary, the p-type nitride layer and the light emitting active layer may be formed in a hydrogen atmosphere to improve crystal quality. In this case, since the buffer layer has already been formed, the respective layers are not affected by etching of the ZnO powders even in the hydrogen atmosphere when forming the respective layers. In addition, in this case, some or all of the ZnO powders are etched to form air holes between the growth substrate and the buffer layer. Such air holes serve as an irregular reflection layer, thereby improving brightness of the nitride-based light emitting device.

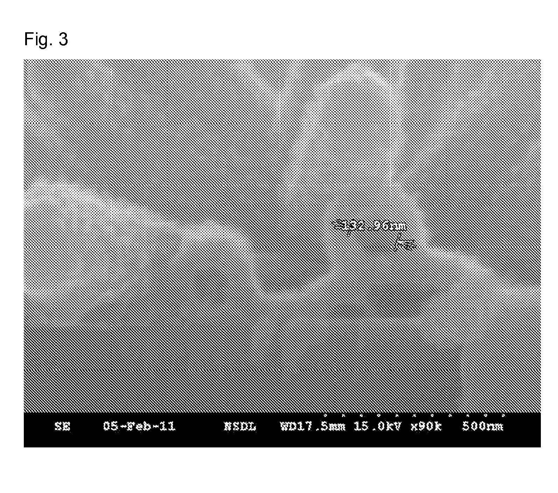

Fig. 3 is an SEM image showing air holes formed by etching ZnO powders during growth of a nitride layer.

Referring to Fig. 3, it can be seen that when a nitride layer is grown in a hydrogen atmosphere, ZnO powders are etched such that an etched portion forms an air hole.

In operation S250, a ZnO layer is grown on the light emitting active layer in an atmosphere of nitrogen (N₂), helium (He), oxygen (O₂), or the like at low temperature of about 700∼800°C.

As set forth above, in the method of manufacturing a nitride-based light emitting device according to the embodiment of the invention, a p-type nitride layer is formed on a growth substrate, followed by forming an n-type ZnO layer, which can be grown at relatively low temperature, on a light emitting active layer. As a result, it is possible to improve crystal quality of the p-type nitride layer while minimizing influence of the n-type ZnO on the light emitting active layer during growth of the n-type ZnO layer.

In addition, in the method of manufacturing a nitride-based light emitting device according to the embodiment of the invention, a lattice buffer layer is formed of powders of a material having a Wurtzite lattice structure such as ZnO powders, thereby minimizing occurrence of dislocations caused by a difference in lattice constant between the silicon substrate and a nitride layer during growth of the nitride layer while enabling growth of a flat nitride layer.

As such, in the method of manufacturing a nitride-based light emitting device according to the embodiments of the invention, powders of a material having the Wurtzite lattice structure, such as ZnO powders, are coated on a growth substrate and a nitride layer such as GaN is grown thereon. As a result, it is possible to suppress occurrence of dislocations caused by a difference in lattice constant between the nitride layer and the growth substrate during growth of the nitride layer.

Further, in the method of manufacturing a nitride-based light emitting device according to the embodiments of the invention, a p-type nitride layer may be first formed on a growth substrate, thereby improving crystal quality of the p-type nitride layer.

Furthermore, according to the embodiments of the invention, since an n-type ZnO layer capable of being grown at relatively lower temperature than GaN is formed on the light emitting active layer, it is possible to reduce influence on the light emitting active layer.

Although some embodiments have been described herein, it should be understood by those skilled in the art that these embodiments are given by way of illustration only, and that various modifications, variations, and alterations can be made without departing from the spirit and scope of the invention. Therefore, the scope of the invention should be limited only by the accompanying claims and equivalents thereof.

## Claims

1. A nitride-based light emitting device including a light emitting active layer between a p-type nitride layer and an n-type ZnO layer, **characterized by** comprising:
a growth substrate;
a lattice buffer layer formed on the growth substrate;
a p-type nitride layer formed on the lattice buffer layer;
a light emitting active layer formed on the p-type nitride layer; and
an n-type ZnO layer formed on the light emitting active layer,
the lattice buffer layer being formed of powders of a material having a Wurtzite lattice structure.

2. The nitride-based light emitting device of claim 1, **characterized in that** the lattice buffer layer is formed of ZnO powders.

3. The nitride-based light emitting device of claim 2, **characterized in that** the ZnO powders have an average particle size of 10 nm to 1 µm.

4. The nitride-based light emitting device of claim 1, **characterized in that** the growth substrate is a silicon substrate or a sapphire substrate.

5. The nitride-based light emitting device of claim 1, **characterized in that** the growth substrate has an uneven surface.

6. The nitride-based light emitting device of claim 1, further comprising: a nitride buffer layer between the lattice buffer layer and the p-type nitride layer.

7. The nitride-based light emitting device of claim 6, **characterized in that** the nitride buffer layer is formed of at least one nitride selected from AlN, ZrN, and GaN.

8. The nitride-based light emitting device of claim 6, **characterized in that** the nitride buffer layer is formed of a p-type nitride.

9. A method of manufacturing a nitride-based light emitting device including a light emitting active layer between a p-type nitride layer and an n-type ZnO layer, **characterized by** comprising:
forming a lattice buffer layer on a growth substrate using powders of a material having a Wurtzite lattice structure;
forming a buffer layer on the lattice buffer layer;
forming a p-type nitride layer on the buffer layer;
forming a light emitting active layer on the p-type nitride layer; and
forming an n-type ZnO layer on the light emitting active layer.

10. The method of claim 9, **characterized in that** the lattice buffer layer is formed of ZnO powders.

11. The method of claim 10, **characterized in that** the ZnO powders are formed by depositing ZnO onto a silicon or sapphire substrate and pulverizing the ZnO-deposited substrate into powders.

12. The method of claim 10, **characterized in that** the forming the buffer layer is performed in an inert gas atmosphere, and the forming the p-type nitride layer and the forming the light emitting active layer are performed in a hydrogen atmosphere, so that some or all of the ZnO powders are etched by hydrogen gas to form an air hole between the growth substrate and the buffer layer.
